# EUROPEAN PATENT APPLICATION

(11) **EP 2 432 000 A1**
(43) Date of publication of application: **21.03.2012**
(21) Application number: 10774826.1
(22) Date of filing: 27.04.2010
(51) Int. Cl.: H01L 21/02, C30B 29/36, H01L 21/20, H01L 21/336, H01L 29/12, H01L 29/78

(54) **SILICON CARBIDE SUBSTRATE, SEMICONDUCTOR DEVICE, AND METHOD FOR MANUFACTURING SILICON CARBIDE SUBSTRATE**

(30) Priority: 11.05.2009 JP 2009114737; 24.09.2009 JP 2009219065; 01.10.2009 JP 2009229764; 29.10.2009 JP 2009248621
(71) Applicant: Sumitomo Electric Industries, Ltd., Chuo-ku Osaka-shi Osaka 541-0041 (JP)
(72) Inventor: NISHIGUCHI, Taro, Itami-shi Hyogo 664-0016 (JP); SASAKI, Makoto, Itami-shi Hyogo 664-0016 (JP); HARADA, Shin, Osaka-shi Osaka 554-0024 (JP); FUJIWARA, Shinsuke, Itami-shi Hyogo 664-0016 (JP); NAMIKAWA, Yasuo, Osaka-shi Osaka 554-0024 (JP)
(74) Representative: Grünecker, Kinkeldey, Stockmair & Schwanhäusser
(86) International application number: PCT/JP2010/057439
(87) International publication number: WO 2010/131568

(57) **Abstract**

A silicon carbide substrate (1) allowing reduction in cost for manufacturing a semiconductor device including a silicon carbide substrate includes a base substrate (10) composed of silicon carbide and an SiC layer (20) composed of single crystal silicon carbide different from the base substrate (10) and arranged on the base substrate (10) in contact therewith. Thus, the silicon carbide substrate 1 is a silicon carbide substrate capable of making effective use of silicon carbide single crystal.

## Description

### TECHNICAL FIELD

The present invention relates to a silicon carbide substrate, a semiconductor device, and a method of manufacturing a silicon carbide substrate, and more particularly to a silicon carbide substrate allowing reduction in cost for manufacturing a semiconductor device including a silicon carbide substrate and a method of manufacturing the same, as well as a semiconductor device of which manufacturing cost has been reduced.

### BACKGROUND ART

In recent years, in order to achieve a higher breakdown voltage and lower loss of a semiconductor device, use thereof in an environment at high temperature and the like, silicon carbide has increasingly been adopted as a material for a semiconductor device. Silicon carbide is a wide band-gap semiconductor greater in band gap than silicon conventionally widely used as a material for a semiconductor device. Therefore, by adopting silicon carbide as a material for a semiconductor device, a higher breakdown voltage, a lower ON resistance of a semiconductor device and the like can be achieved. In addition, a semiconductor device adopting silicon carbide as a material is also more advantageous than a semiconductor device adopting silicon as a material in that deterioration in its characteristics at the time when it is used in an environment at high temperature is less.

Under such circumstances, various studies have been conducted on a method of manufacturing silicon carbide crystal and a silicon carbide substrate used for manufacturing a semiconductor device, and various ideas have been proposed (see, for example, M. Nakabayashi et al., "Growth of Crack-free 100 mm-diameter 4H-SiC Crystals with Low Micropipe Densities," Mater. Sci. Forum, vols. 600-603, 2009, pp. 3-6 (NPL 1)).

### CITATION LIST

### NON PATENT LITERATURE

NPL 1: M. Nakabayashi et al., "Growth of Crack-free 100 mm-diameter 4H-SiC Crystals with Low Micropipe Densities," Mater. Sci. Forum, vols. 600-603, 2009, pp. 3-6

### SUMMARY OF INVENTION

### TECHNICAL PROBLEM

Silicon carbide, however, is not in a liquid phase at a normal pressure. In addition, a crystal growth temperature is very high, i.e., 2000°C or higher, and control of a growth condition or stable control is difficult. Therefore, it is difficult to obtain large-diameter silicon carbide single crystal while maintaining high quality, and it is not easy to obtain a high-quality silicon carbide substrate having a large diameter. Owing to difficulty in fabrication of a silicon carbide substrate having a large diameter, not only cost for manufacturing a silicon carbide substrate increases but also the number of products per one batch is small in manufacturing semiconductor devices including the silicon carbide substrates, and hence cost for manufacturing semiconductor devices increases. By making effective use of silicon carbide single crystal high in manufacturing cost as a substrate, it is expected that cost for manufacturing a semiconductor device can be reduced.

An object of the present invention is to provide a silicon carbide substrate allowing reduction in cost for manufacturing a semiconductor device including a silicon carbide substrate and a method of manufacturing the same, as well as a semiconductor device of which manufacturing cost has been reduced.

### SOLUTION TO PROBLEM

A silicon carbide substrate according to the present invention includes a base substrate composed of silicon carbide and an SiC layer composed of single crystal silicon carbide different from the base substrate and arranged on the base substrate in contact therewith.

As described above, it is difficult to obtain large-diameter silicon carbide single crystal of high quality. On the other hand, for efficient manufacturing in a process for manufacturing semiconductor devices each including a silicon carbide substrate, substrates uniform in prescribed shape and size are required. Therefore, even when silicon carbide single crystal of high quality (for example, silicon carbide single crystal low in fault density) is obtained, effective use of a region that cannot be worked to a prescribed shape or the like by cutting or the like may not be made.

In contrast, in the silicon carbide substrate according to the present invention, an SiC layer composed of single crystal silicon carbide different from the base substrate is arranged on the base substrate. Therefore, for example, a base substrate composed of silicon carbide crystal high in fault density and low in quality can be worked to the prescribed shape and size above so that silicon carbide single crystal not having a desired shape or the like although having high quality can be arranged on the base substrate as an SiC layer. Such silicon carbide substrates are uniform in prescribed shape and size, and thus more efficient manufacturing of semiconductor devices can be achieved. In addition, since semiconductor devices can be manufactured with the use of high-quality SiC layers for such silicon carbide substrates, effective use of silicon carbide single crystal can be made. Consequently, according to the silicon carbide substrate in the present invention, a silicon carbide substrate allowing reduction in cost for manufacturing a semiconductor device including a silicon carbide substrate can be provided. Here, such a state that the SiC layer above is composed of single crystal silicon carbide different from the base substrate includes a case where the base substrate is composed of silicon carbide other than single crystal, such as polycrystalline and amorphous silicon carbide, and a case where the base substrate is composed of single crystal silicon carbide and made of crystal different from the SiC layer. A state in which the base substrate and the SiC layer are composed of crystals different from each other means a state that a boundary is present between the base substrate and the SiC layer, and for example, fault density is different between one side and the other side of the boundary. Here, fault density may be discontinuous at the boundary.

In the silicon carbide substrate above, preferably, the base substrate is composed of single crystal silicon carbide. The SiC layer is lower in micropipe density than the base substrate.

In addition, in the silicon carbide substrate above, preferably, the base substrate is composed of single crystal silicon carbide. The SiC layer is preferably lower in dislocation density than the base substrate. More specifically, in the silicon carbide substrate above, preferably, the base substrate is composed of single crystal silicon carbide. Then, the SiC layer is lower in threading screw dislocation density than the base substrate.

In addition, in the silicon carbide substrate above, preferably, the base substrate is composed of single crystal silicon carbide. The SiC layer is lower in threading edge dislocation density than the base substrate.

In addition, in the silicon carbide substrate above, preferably, the base substrate is composed of single crystal silicon carbide. The SiC layer is lower in basal plane dislocation density than the base substrate.

In addition, in the silicon carbide substrate above, preferably, the base substrate is composed of single crystal silicon carbide. The SiC layer is lower in composite dislocation density than the base substrate.

In addition, in the silicon carbide substrate above, preferably, the base substrate is composed of single crystal silicon carbide. The SiC layer is lower in stacking fault density than the base substrate.

In addition, in the silicon carbide substrate above, preferably, the base substrate is composed of single crystal silicon carbide. The SiC layer is lower in point defect density than the base substrate.

As described above, a silicon carbide substrate allowing manufacturing of a semiconductor device of high quality can be obtained by arranging an SiC layer lower than the base substrate in fault density such as micropipe density, dislocation density (threading screw dislocation density, threading edge dislocation density, basal plane dislocation density, composite dislocation density, stacking fault density, point defect density), or the like.

In the silicon carbide substrate above, preferably, the base substrate is composed of single crystal silicon carbide. The SiC layer is smaller in a full width at half maximum of X-ray rocking curve than the base substrate. Thus, a silicon carbide substrate allowing manufacturing of a semiconductor device of high quality can be obtained by arranging an SiC layer smaller in a full width at half maximum of X-ray rocking curve, that is, higher in crystallinity, than the base substrate.

In the silicon carbide substrate above, the base substrate may include a single crystal layer composed of single crystal silicon carbide so as to include a main surface on a side facing the SiC layer. By doing so, in manufacturing a semiconductor device including a silicon carbide substrate, such a state of a large thickness as readily being handled is maintained in an early stage of a manufacturing process, and during the manufacturing process, a region of the base substrate other than a single crystal layer is removed to allow only the single crystal layer of the base substrate to remain in the inside of the semiconductor device. Thus, a semiconductor device of high quality can be manufactured while handling of a silicon carbide substrate in the manufacturing process is facilitated.

In the silicon carbide substrate above, preferably, the SiC layer is lower in micropipe density than the single crystal layer above.

In addition, in the silicon carbide substrate above, preferably, the SiC layer is lower in dislocation density than the single crystal layer above. More specifically, in the silicon carbide substrate above, preferably, the SiC layer is lower in threading screw dislocation density than the single crystal layer above.

In addition, in the silicon carbide substrate above, preferably, the SiC layer is lower in threading edge dislocation density than the single crystal layer above.

In addition, in the silicon carbide substrate above, preferably, the SiC layer is lower in basal plane dislocation density than the single crystal layer above.

In addition, in the silicon carbide substrate above, preferably, the SiC layer is lower in composite dislocation density than the single crystal layer above.

In addition, in the silicon carbide substrate above, preferably, the SiC layer is lower in stacking fault density than the single crystal layer above.

In addition, in the silicon carbide substrate above, preferably, the SiC layer is lower in point defect density than the single crystal layer above.

Thus, a silicon carbide substrate allowing manufacturing of a semiconductor device of high quality can be obtained by arranging an SiC layer lower than the single crystal layer of the base substrate in fault density such as micropipe density, dislocation density (threading screw dislocation density, threading edge dislocation density, basal plane dislocation density, composite dislocation density, stacking fault density, point defect density), or the like.

In the silicon carbide substrate above, preferably, the SiC layer is smaller in a full width at half maximum of X-ray rocking curve than the single crystal layer above. Thus, a silicon carbide substrate allowing manufacturing of a semiconductor device of high quality can be obtained by arranging an SiC layer smaller in a full width at half maximum of X-ray rocking curve, that is, higher in crystallinity, than the single crystal layer of the base substrate.

In the silicon carbide substrate above, impurity density in the base substrate can be not lower than 5×10¹⁸ cm⁻³. Thus, carrier density in the base substrate increases so that a silicon carbide substrate suitable for manufacturing, for example, a vertical semiconductor device in which an electrode is formed on a main surface of the base substrate opposite to the side where the SiC layer is formed and a current path crosses the base substrate in a direction of thickness, can be obtained.

In the silicon carbide substrate above, the base substrate can have resistivity not lower than 1×10⁵ Ω·cm. Thus, a resistance value of the base substrate increases, and a silicon carbide substrate suitable for manufacturing, for example, a semiconductor device which is a lateral semiconductor device in which a current flows in a direction along a main surface of the base substrate and is required to adapt to a higher frequency can be obtained.

In the silicon carbide substrate above, a plurality of SiC layers above may be stacked. Thus, a silicon carbide substrate including SiC layers in accordance with an intended structure of a semiconductor device can be obtained.

In the silicon carbide substrate above, preferably, a plurality of SiC layers are two-dimensionally arranged in alignment. Giving the description from a different point of view, a plurality of SiC layers are preferably arranged in alignment along a main surface of the base substrate. As described above, it is difficult to obtain large-diameter silicon carbide single crystal of high quality. In contrast, a plurality of SiC layers taken from silicon carbide single crystal of high quality are two-dimensionally arranged in alignment on the base substrate of a large diameter, so that a silicon carbide substrate that can be handled as a large-diameter substrate having SiC layers of high quality can be obtained. Then, by using this silicon carbide substrate, efficiency in a process for manufacturing a semiconductor device can be improved. In order to improve efficiency in a process for manufacturing a semiconductor device, SiC layers adjacent to each other among the plurality of SiC layers above are preferably arranged in contact with each other. More specifically, for example, the plurality of SiC layers above are preferably two-dimensionally paved in matrix. In addition, end surfaces of respective adjacent SiC layers are preferably substantially perpendicular to the main surface of the SiC layer. Thus, a silicon carbide substrate can readily be manufactured. Here, it can be determined that the end surface above is substantially perpendicular to the main surface, for example, if an angle between the end surface above and the main surface is not smaller than 85° and not greater than 95°.

In the silicon carbide substrate above, a main surface of the SiC layer opposite to the base substrate has an off angle with respect to a plane orientation {0001} not smaller than 50° and not greater than 65°.

Hexagonal silicon carbide single crystal is grown in a <0001> direction, so that single crystal of high quality can efficiently be fabricated. Then, a silicon carbide substrate having a {0001} plane as the main surface can efficiently be taken from silicon carbide single crystal grown in the <0001> direction. Meanwhile, in some cases, a semiconductor device of high performance can be manufactured with a silicon carbide substrate including a main surface having an off angle with respect to plane orientation {0001} not smaller than 50° and not greater than 65°, such as a main surface having a plane orientation {03-38}. When a silicon carbide substrate including a main surface having an off angle with respect to plane orientation {0001} not smaller than 50° and not greater than 65° is taken from silicon carbide single crystal grown in the <0001> direction, however, effective use of many portions in silicon carbide single crystal is not made.

In contrast, according to the silicon carbide substrate in the present invention above, since silicon carbide single crystal indefinite in shape can be used as an SiC layer, effective use of silicon carbide single crystal can be made even though the main surface of the SiC layer has an off angle with respect to plane orientation {0001} not smaller than 50° and not greater than 65°. In addition, by two-dimensionally arranging a plurality of SiC layers in alignment, a large-diameter silicon carbide substrate having a main surface of which off angle with respect to plane orientation {0001} is not smaller than 50° and not greater than 65°, which makes it difficult to achieve a large diameter, such as a main surface having plane orientation {03-38}, can readily be obtained.

In the silicon carbide substrate above, an angle between an off orientation of the main surface above and a <1-100> direction may be not greater than 5°. The<1-100> direction is a representative off orientation in a silicon carbide substrate. By setting variation in off orientation originating from variation or the like in slice working in the process for manufacturing a substrate to 5° or smaller, formation or the like of an epitaxially grown layer on a silicon carbide substrate can be facilitated.

In the silicon carbide substrate above, an off angle of the main surface above with respect to a {03-38} plane in the <1-100> direction can be not smaller than -3° and not greater than 5°. Thus, channel mobility in a case where a MOSFET or the like is fabricated with a silicon carbide substrate can further be improved. Here, the reason why an off angle with respect to plane orientation {03-38} is set to -3° or greater and +5° or smaller is based on the fact that particularly high channel mobility was obtained in this range as a result of examination of relation between channel mobility and the off angle.

The "off angle with respect to the {03-38} plane in the <1-100> direction" refers to an angle formed by an orthogonal projection of a normal line of the main surface above to a projection plane defined by the <1-100> direction and the <0001> direction, and a normal line of the {03-38} plane. The sign of positive value corresponds to a case where the orthogonal projection approaches in parallel with the <1-100> direction, whereas the sign of negative value corresponds to a case where the orthogonal projection approaches in parallel with the <0001> direction.

It is noted that, more preferably, the plane orientation of the main surface above is substantially {03-38}, and further preferably, the plane orientation of the main surface above is {03-38}. Here, the plane orientation of the main surface being substantially {03-38} means that the plane orientation of the main surface of the substrate is included in a range of off angles in which the plane orientation can be regarded substantially as {03-38} in consideration of working accuracy or the like of the substrate, and the range of off angles in this case is a range, for example, of off angles ±2° with respect to {03-38}. Channel mobility described above can thus further be improved.

In the silicon carbide substrate above, an angle between an off orientation of the main surface above and a <11-20> direction may be not greater than 5°. Likewise the <1-100> direction above, the <11-20> direction is a representative off orientation in a silicon carbide substrate. By setting variation in off orientation originating from variation or the like in slice working in the process for manufacturing a substrate to ±5°, formation or the like of an epitaxially grown layer on a silicon carbide substrate can be facilitated.

In the silicon carbide substrate above, preferably, a main surface of the SiC layer opposite to the base substrate is polished. Thus, an epitaxially grown layer of high quality can be formed on a main surface of the SiC layer opposite to the base substrate. Consequently, a semiconductor device including the epitaxially grown layer of high quality, for example, as an active layer, can be manufactured. Namely, by adopting such a structure, a silicon carbide substrate allowing manufacturing of a high-quality semiconductor device including an epitaxial layer formed on the SiC layer can be obtained.

A semiconductor device according to the present invention includes a silicon carbide substrate, an epitaxially grown layer formed on the silicon carbide substrate, and an electrode formed on the epitaxially grown layer. Then, the silicon carbide substrate is the silicon carbide substrate according to the present invention above. According to the semiconductor device of the present invention, by including the silicon carbide substrate according to the present invention above, a semiconductor device of which manufacturing cost has been reduced can be provided.

A method of manufacturing a silicon carbide substrate according to the present invention includes the steps of preparing a base substrate composed of silicon carbide and an SiC substrate composed of single crystal silicon carbide, fabricating a stack substrate by placing the SiC substrate on a main surface of the base substrate in contact therewith, and bonding the base substrate and the SiC substrate to each other by heating the stack substrate. Thus, the silicon carbide substrate according to the present invention above can readily be manufactured.

In the method of manufacturing a silicon carbide substrate above, preferably, in the stack substrate above, a gap formed between the base substrate and the SiC substrate is not greater than 100 µm.

The base substrate and the SiC substrate have slight warpage or waviness even though their planarity is high. Therefore, a gap is formed between the base substrate and the SiC substrate in the stack substrate. The present inventor's studies revealed that this gap exceeding 100 µm leads to a non-uniform bonding state between the base substrate and the SiC substrate. Therefore, uniform bonding between the base substrate and the SiC substrate can be achieved by setting a gap formed between the base substrate and the SiC substrate to 100 µm or smaller.

In the method of manufacturing a silicon carbide substrate above, preferably, in the step of bonding the base substrate and the SiC substrate to each other, the stack substrate is heated to a temperature range not lower than a sublimation temperature of silicon carbide. Thus, the base substrate and the SiC substrate can more reliably be bonded to each other. Here, the "temperature range not lower than a sublimation temperature of silicon carbide" does not necessarily have to be a temperature range not lower than a sublimation point temperature of silicon carbide, but it should only be a temperature range in which a phenomenon of sublimation of silicon carbide occurs, such as a temperature range not lower than 1800°C.

The method of manufacturing a silicon carbide substrate above preferably further includes the step of planarizing respective main surfaces of the base substrate and the SiC substrate to be in contact with each other in the step of fabricating a stack substrate, prior to the step of fabricating a stack substrate. By planarizing the surface to become a bonding surface between the base substrate and the SiC substrate in advance, the base substrate and the SiC substrate can more reliably be bonded to each other.

In the method of manufacturing a silicon carbide substrate above, the step of fabricating a stack substrate may be performed without polishing respective main surfaces of the base substrate and the SiC substrate to be in contact with each other in the step of fabricating a stack substrate, prior to the step of fabricating a stack substrate. Thus, cost for manufacturing a silicon carbide substrate can be reduced. In particular, as the stack substrate is heated to a temperature range not lower than a sublimation temperature of silicon carbide in the step of bonding the base substrate and the SiC substrate to each other, the base substrate and the SiC substrate can readily be bonded to each other even though the base substrate and the SiC substrate are not polished. Here, main surfaces of the base substrate and the SiC substrate to be in contact with each other in the step of fabricating a stack substrate do not have to be polished as described above. From a point of view of removal of a damaged layer around the surface caused by slicing during fabrication of a substrate, however, the step of fabricating a stack substrate above is preferably performed after the step of removing the damaged layer, for example, by etching, is performed.

In the method of manufacturing a silicon carbide substrate above, a plurality of SiC substrates may be stacked on the base substrate in the step of fabricating a stack substrate. Thus, a silicon carbide substrate formed by stacking a plurality of SiC layers can be manufactured.

In the method of manufacturing a silicon carbide substrate above, in the step of fabricating a stack substrate, a plurality of SiC substrates may two-dimensionally be placed in alignment. Giving the description from a different point of view, a plurality of SiC substrates may be placed in alignment along a main surface of the base substrate. Thus, a silicon carbide substrate that can be handled as a large-diameter substrate having SiC layers of high quality can be manufactured.

The method of manufacturing a silicon carbide substrate above may further include the steps of fabricating a second stack substrate by stacking another SiC substrate on the SiC substrate, and bonding the stack substrate and another SiC substrate above to each other by heating the second stack substrate, after the step of bonding the base substrate and the SiC substrate to each other. A silicon carbide substrate in which a plurality of SiC layers are stacked can readily be manufactured by repeatedly performing the step of placing the SiC substrate and the step of bonding the SiC substrate.

In the method of manufacturing a silicon carbide substrate above, in the step of fabricating a second stack substrate, a plurality of other SiC substrates above may two-dimensionally be placed in alignment. Giving the description from a different point of view, other SiC substrates above may be placed in alignment along the main surface of the base substrate. Thus, a silicon carbide substrate that can be handled as a large-diameter substrate having a plurality of SiC layers of high quality can be manufactured.

In the method of manufacturing a silicon carbide substrate above, the step of fabricating a second stack substrate above may be performed without polishing respective main surfaces of the SiC substrate and another SiC substrate to be in contact with each other in the step of fabricating a second stack substrate, prior to the step of fabricating a second stack substrate. Thus, cost for manufacturing a silicon carbide substrate can be reduced.

In the method of manufacturing a silicon carbide substrate above, in the step of fabricating a stack substrate, a main surface of the SiC substrate opposite to the base substrate may have an off angle with respect to a {0001} plane not smaller than 50° and not greater than 65°. Thus, a silicon carbide substrate of which main surface of the SiC layer opposite to the base substrate has an off angle with respect to the {0001} plane not smaller than 50° and not greater than 65° can readily be manufactured.

In the method of manufacturing a silicon carbide substrate above, in the step of fabricating a stack substrate, an angle between an off orientation of the main surface of the SiC substrate opposite to the base substrate and a <1-100> direction may be not greater than 5°. Thus, formation or the like of an epitaxially grown layer on a fabricated silicon carbide substrate can be facilitated.

In the method of manufacturing a silicon carbide substrate above, in the step of fabricating a stack substrate, an off angle of the main surface of the SiC substrate opposite to the base substrate with respect to a {03-38} plane in the <1-100> direction may be not smaller than -3° and not greater than 5°. Thus, channel mobility in a case where a MOSFET or the like is fabricated with a manufactured silicon carbide substrate can further be improved.

In the method of manufacturing a silicon carbide substrate above, in the step of fabricating a stack substrate, an angle between an off orientation of the main surface of the SiC substrate opposite to the base substrate and a <11-20> direction may be not greater than 5°. Thus, formation or the like of an epitaxially grown layer on a fabricated silicon carbide substrate can be facilitated.

In the method of manufacturing a silicon carbide substrate above, in the step of bonding the base substrate and the SiC substrate to each other, the stack substrate may be heated in an atmosphere obtained by reducing a pressure of an ambient air atmosphere. Thus, cost for manufacturing a silicon carbide substrate can be reduced.

In the method of manufacturing a silicon carbide substrate above, in the step of bonding the base substrate and the SiC substrate to each other, the stack substrate above may be heated at a pressure higher than 10⁻¹ Pa and lower than 10⁴ Pa. Thus, bonding above can be achieved with a simplified apparatus and an atmosphere for carrying out bonding in a relatively short period of time can be obtained, and thus cost for manufacturing a silicon carbide substrate can be reduced.

The method of manufacturing a silicon carbide substrate above may further include the step of polishing a main surface of the SiC substrate corresponding to a main surface of the SiC substrate opposite to the base substrate in the stack substrate. Thus, an epitaxially grown layer of high quality can be formed on a main surface of the SiC layer (SiC substrate) opposite to the base substrate. Consequently, a semiconductor device including the epitaxially grown layer of high quality, for example, as an active layer, can be manufactured. Namely, by adopting such a step, a silicon carbide substrate allowing manufacturing of a high-quality semiconductor device including an epitaxial layer formed on the SiC layer above can be obtained. Here, the main surface of the SiC substrate may be polished after the base substrate and the SiC substrate are bonded to each other, or it may be polished before the step of fabricating a stack substrate by polishing in advance the main surface of the SiC substrate to serve as the main surface opposite to the base substrate in the stack substrate above.

### ADVANTAGEOUS EFFECTS OF INVENTION

As is clear from the description above, according to the silicon carbide substrate and the method of manufacturing the same of the present invention, a silicon carbide substrate allowing reduction in cost for manufacturing a semiconductor device including a silicon carbide substrate and a method of manufacturing the same can be provided. In addition, according to a semiconductor device of the present invention, a semiconductor device of which manufacturing cost has been reduced can be provided.

### BRIEF DESCRIPTION OF DRAWINGS

Fig. 1 is a schematic cross-sectional view showing a structure of a silicon carbide substrate.
Fig. 2 is a flowchart showing an outline of a method of manufacturing a silicon carbide substrate.
Fig. 3 is a schematic cross-sectional view showing a structure of a silicon carbide substrate.
Fig. 4 is a flowchart showing an outline of a method of manufacturing a silicon carbide substrate.
Fig. 5 is a schematic cross-sectional view showing a structure of a silicon carbide substrate.
Fig. 6 is a schematic plan view showing a structure of a silicon carbide substrate.
Fig. 7 is a schematic cross-sectional view showing a structure of a vertical MOSFET.
Fig. 8 is a flowchart showing an outline of a method of manufacturing a vertical MOSFET.
Fig. 9 is a schematic cross-sectional view for illustrating the method of manufacturing a vertical MOSFET.
Fig. 10 is a schematic cross-sectional view for illustrating the method of manufacturing a vertical MOSFET.
Fig. 11 is a schematic cross-sectional view for illustrating the method of manufacturing a vertical MOSFET.
Fig. 12 is a schematic cross-sectional view for illustrating the method of manufacturing a vertical MOSFET.
Fig. 13 is a schematic cross-sectional view showing a position of EBSD analysis.
Fig. 14 shows an EBSD pattern at a position A in Fig. 13.
Fig. 15 shows an EBSD pattern at a position B in Fig. 13.

### DESCRIPTION OF EMBODIMENTS

An embodiment of the present invention will be described hereinafter with reference to the drawings. In the drawings below, the same or corresponding elements have the same reference characters allotted and description thereof will not be repeated.

### (First Embodiment)

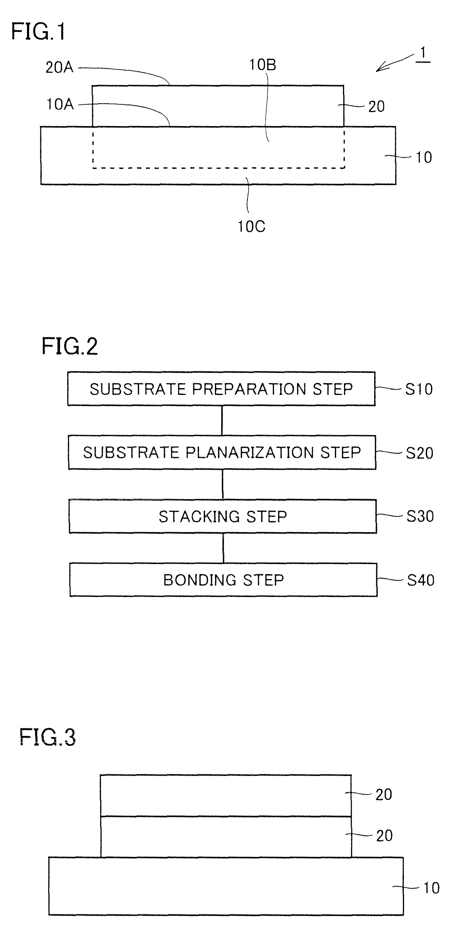

Initially, a structure of a silicon carbide substrate in a first embodiment representing one embodiment of the present invention will be described. Referring to Fig. 1, a silicon carbide substrate 1 in the present embodiment includes a base substrate 10 composed of silicon carbide and an SiC layer 20 composed of single crystal silicon carbide different from base substrate 10 and arranged on base substrate 10 in contact therewith.

With such a structure, in silicon carbide substrate 1, base substrate 10 composed of silicon carbide crystal, for example, high in fault density and low in quality can be worked to prescribed shape and size so that silicon carbide single crystal not having a desired shape or the like although being of high quality can be arranged on base substrate 10 as SiC layer 20. Such silicon carbide substrates 1 are uniform in prescribed shape and size, and thus more efficient manufacturing of a semiconductor device can be achieved. In addition, since semiconductor devices can be manufactured with the use of SiC layers 20 of high quality for silicon carbide substrates 1, effective use of silicon carbide single crystal can be made. Consequently, silicon carbide substrate 1 in the present embodiment is a silicon carbide substrate allowing reduction in cost for manufacturing a semiconductor device.

Here, in silicon carbide substrate 1, base substrate 10 is preferably composed of single crystal silicon carbide. Thus, difference in various physical property values from SiC layer 20 composed of single crystal silicon carbide becomes small, and hence a silicon carbide substrate stable in particular in a process for manufacturing a semiconductor device under various environments is obtained.

In silicon carbide substrate 1 above, preferably, SiC layer 20 is lower in micropipe density than base substrate 10. In addition, in silicon carbide substrate 1. preferably, SiC layer 20 is lower in threading screw dislocation density than base substrate 10. In addition, in silicon carbide substrate 1, preferably, SiC layer 20 is lower in threading edge dislocation density than base substrate 10. In addition, in silicon carbide substrate 1, preferably, SiC layer 20 is lower in basal plane dislocation density than base substrate 10. In addition, in silicon carbide substrate 1, preferably, SiC layer 20 is lower in composite dislocation density than base substrate 10. In addition, in silicon carbide substrate 1, preferably, SiC layer 20 is lower in stacking fault density than base substrate 10. In addition, in silicon carbide substrate 1, preferably, SiC layer 20 is lower in point defect density than base substrate 10. Silicon carbide substrate 1 allowing manufacturing of a semiconductor device of high quality can be obtained by thus arranging SiC layer 20 lower in fault density than base substrate 10. Further, in silicon carbide substrate 1, preferably, SiC layer 20 is smaller in a full width at half maximum of X-ray rocking curve than SiC layer 20. Thus, silicon carbide substrate 1 allowing manufacturing of a semiconductor device of high quality can be obtained by arranging SiC layer 20 smaller in a full width at half maximum of X-ray rocking curve, that is, higher in crystallinity, than base substrate 10.

Referring again to Fig. 1, in silicon carbide substrate 1, base substrate 10 may include a single crystal layer 10B composed of single crystal silicon carbide so as to include a main surface 10A on the side facing SiC layer 20. By doing so, in manufacturing a semiconductor device including silicon carbide substrate 1, such a state of a large thickness as readily being handled is maintained in an early stage of the manufacturing process, and during the manufacturing process, a region 10C of the base substrate other than single crystal layer 10B is removed to allow only single crystal layer 10B of base substrate 10 to remain in the inside of the semiconductor device. Thus, a semiconductor device of high quality can be manufactured while handling of silicon carbide substrate 1 in the manufacturing process is facilitated.

In addition, in silicon carbide substrate 1, SiC layer 20 is preferably lower in micropipe density than single crystal layer 10B. In addition, in silicon carbide substrate 1, preferably, SiC layer 20 is lower in threading screw dislocation density than single crystal layer 10B. In addition, in silicon carbide substrate 1, preferably, SiC layer 20 is lower in threading edge dislocation density than single crystal layer 10B.

In addition, in silicon carbide substrate 1, preferably, SiC layer 20 is lower in basal plane dislocation density than single crystal layer 10B above. In addition, in silicon carbide substrate 1 above, preferably, SiC layer 20 is lower in composite dislocation density than single crystal layer 10B. In addition, in silicon carbide substrate 1, preferably, SiC layer 20 is lower in stacking fault density than single crystal layer 10B. In addition, in silicon carbide substrate 1, preferably, SiC layer 20 is lower in point defect density than single crystal layer 10B. Thus, silicon carbide substrate 1 allowing manufacturing of a semiconductor device of high quality can be obtained by arranging SiC layer 20 lower in fault density than single crystal layer 10B of base substrate 10.

In addition, in silicon carbide substrate 1, preferably, SiC layer 20 is smaller in a full width at half maximum of X-ray rocking curve than single crystal layer 10B. Thus, silicon carbide substrate 1 allowing manufacturing of a semiconductor device of high quality can be obtained by arranging SiC layer 20 smaller in a full width at half maximum of X-ray rocking curve, that is, higher in crystallinity, than single crystal layer 10B of base substrate 10.

In silicon carbide substrate 1 in the present embodiment, impurity density in base substrate 10 can be not lower than 5×10¹⁸ cm⁻³. Thus, carrier density in base substrate 10 increases and silicon carbide substrate 1 suitable for manufacturing a vertical semiconductor device can be obtained. In addition, impurity concentration in base substrate 10 can be higher than 2×10¹⁹ cm⁻³. Then, impurity concentration in SiC layer 20 can be higher than 5×10¹⁸ cm⁻³ and lower than 2×10¹⁹ cm⁻³. Thus, resistivity in a direction of thickness can be lowered while suppressing generation of stacking faults caused by heat treatment.

In silicon carbide substrate 1 in the present embodiment, resistivity of base substrate 10 can be not lower than 1×10⁵ Ω·cm. Thus, a resistance value of base substrate 10 increases and silicon carbide substrate 1 suitable for manufacturing a lateral semiconductor device required to adapt to a higher frequency can be obtained.

In silicon carbide substrate 1 in the present embodiment, a main surface 20A of SiC layer 20 opposite to base substrate 10 may have an off angle with respect to a plane orientation {0001} not smaller than 50° and not greater than 65°. Thus, silicon carbide substrate 1 allowing manufacturing of a high-performance semiconductor device while making effective use of silicon carbide single crystal can be obtained.

In silicon carbide substrate 1, an angle between an off orientation of main surface 20A and a <1-100> direction may be not greater than 5°. The<1-100> direction is a representative off orientation in the silicon carbide substrate. By setting variation in off orientation originating from variation or the like in slice working in the process for manufacturing silicon carbide substrate 1 to 5° or smaller, formation or the like of an epitaxially grown layer on silicon carbide substrate 1 (on main surface 20A) can be facilitated. Further, in silicon carbide substrate 1, an off angle of main surface 20A with respect to a {03-38} plane in the <1-100> direction can be not smaller than -3° and not greater than 5°. Thus, channel mobility in a case where a MOSFET or the like is fabricated with silicon carbide substrate 1 can further be improved.

Meanwhile, in silicon carbide substrate 1, an angle between an off orientation of main surface 20A and a <11-20> direction may be not greater than 5°. Likewise the <1-100> direction above, the <11-20> direction is a representative off orientation in a silicon carbide substrate. By setting variation in off orientation originating from variation or the like in slice working in the process for manufacturing silicon carbide substrate 1 to ±5°, formation or the like of an epitaxially grown layer on SiC layer 20 can be facilitated.

In silicon carbide substrate 1 in the present embodiment, preferably, main surface 20A of SiC layer 20 opposite to base substrate 10 is polished. Thus, an epitaxially grown layer of high quality can be formed on main surface 20A. Consequently, a semiconductor device including the epitaxially grown layer of high quality, for example, as an active layer, can be manufactured. Namely, by adopting such a structure, silicon carbide substrate 1 allowing manufacturing of a high-quality semiconductor device including an epitaxial layer formed on SiC layer 20 can be obtained.

A method of manufacturing silicon carbide substrate 1 above will now be described. Referring to Fig. 2, in the method of manufacturing a silicon carbide substrate in the present embodiment, initially, a substrate preparation step is performed as the step (S10). In this step (S10), base substrate 10 composed of silicon carbide and SiC substrate 20 composed of single crystal silicon carbide are prepared.

Then, a substrate planarization step is performed as the step (S20). In this step (S20), respective main surfaces (bonding surfaces) of base substrate 10 and SiC substrate 20 to be in contact with each other in the step (S30) which will be described later are planarized, for example, by polishing. Though this step (S20) is not an essential step, a size of a gap between base substrate 10 and SiC substrate 20 opposed to each other becomes uniform by performing this step and hence uniformity in reaction (bonding) in the bonding surface in the step (S40) which will be described later is improved. Consequently, base substrate 10 and SiC substrate 20 can more reliably be bonded to each other. In addition, in order to further reliably bond base substrate 10 and the SiC substrate to each other, surface roughness Ra of the bonding surface above is preferably less than 100 nm and preferably less than 50 nm. Moreover, by setting surface roughness Ra of the bonding surface to less than 10 nm, further reliable bonding can be achieved.

On the other hand, the step (S20) may be omitted and the step (S30) may be performed without polishing respective main surfaces of base substrate 10 and SiC substrate 20 to be in contact with each other. Cost for manufacturing silicon carbide substrate 1 can thus be reduced. Further, from a point of view of removal of a damaged layer around the surface caused by slicing or the like at the time of fabrication of base substrate 10 and SiC substrate 20, for example, the step of removing the damaged layer by etching may be performed instead of or after the step (S20) above, and then the step (S30) which will be described later may be performed.

Then, a stacking step is performed as the step (S30). In this step (S30), SiC substrate 20 is placed on the main surface of base substrate 10 in contact therewith so that a stack substrate is fabricated. Here, in this step (S30), main surface 20A of SiC substrate 20 opposite to base substrate 10 may have an off angle with respect to the {0001} plane not smaller than 50° and not greater than 65°. Thus, silicon carbide substrate 1 in which main surface 20A of SiC layer 20 has an off angle with respect to the {0001} plane not smaller than 50° and not greater than 65° can readily be manufactured. In addition, in step (S30), an angle between an off orientation of main surface 20A above and the <1-100> direction may be not greater than 5°. Thus, formation or the like of an epitaxially grown layer on fabricated silicon carbide substrate 1 (on main surface 20A) can be facilitated. Further, in step (S30), an off angle of main surface 20A with respect to a {03-38} plane in the <1-100> direction may be not smaller than -3° and not greater than 5°. Thus, channel mobility in a case where a MOSFET or the like is fabricated with manufactured silicon carbide substrate 1 can further be improved.

Meanwhile, in the step (S30), an angle between an off orientation of main surface 20A and a <11-20> direction may be not greater than 5°. Thus, formation or the like of an epitaxially grown layer on fabricated silicon carbide substrate 1 can be facilitated.

Then, a bonding step is performed as the step (S40). In this step (S40), base substrate 10 and SiC substrate 20 are bonded to each other by heating the stack substrate above. Through the process above, silicon carbide substrate 1 in the first embodiment including bonded SiC substrate 20 as SiC layer 20 can readily be manufactured. In this step (S40), the stack substrate above may be heated in an atmosphere obtained by reducing a pressure of an ambient air atmosphere. Thus, cost for manufacturing silicon carbide substrate 1 can be reduced.

Here, in the stack substrate fabricated in the step (S30), a gap formed between base substrate 10 and SiC substrate 20 is preferably not greater than 100 µm. Thus, uniform bonding between base substrate 10 and SiC substrate 20 can be achieved in the step (S40).

In the step (S40) above, the stack substrate above is preferably heated to a temperature range not lower than a sublimation temperature of silicon carbide. Thus, base substrate 10 and SiC substrate 20 can more reliably be bonded to each other. In particular, by setting a gap formed between base substrate 10 and SiC substrate 20 to 100 µm or smaller in the stack substrate, equal bonding by sublimation of SiC can be achieved.

A temperature for heating the stack substrate in the step (S40) is preferably not lower than 1800°C and not higher than 2500°C. When a heating temperature is lower than 1800°C, it takes long time to achieve bonding between base substrate 10 and SiC substrate 20 and efficiency in manufacturing silicon carbide substrate 1 is lowered. On the other hand, when a heating temperature exceeds 2500°C, respective surfaces of base substrate 10 and SiC substrate 20 roughen and more crystal defects in fabricated silicon carbide substrate 1 are likely. In order to improve manufacturing efficiency while generation of defects in silicon carbide substrate 1 is further suppressed, a temperature for heating the stack substrate in the step (S40) is preferably not lower than 1900°C and not higher than 2100°C. In addition, by setting a pressure of an atmosphere during heating in the step (S40) to 10⁻⁵ Pa or higher and 10⁶ Pa or lower, bonding above can be carried out with a simplified apparatus. Moreover, in this step (S40), the stack substrate above may be heated at a pressure higher than 10⁻¹ Pa and lower than 10⁴ Pa. Thus, bonding above can be carried out with a simplified apparatus and an atmosphere for carrying out bonding can be obtained in a relatively short period of time, and thus cost for manufacturing silicon carbide substrate 1 can be reduced. Further, an atmosphere during heating in the step (S40) may be an inert gas atmosphere. In adopting an inert gas atmosphere as the atmosphere, an inert gas atmosphere containing at least one selected from the group consisting of argon, helium and nitrogen is preferred.

The method of manufacturing silicon carbide substrate 1 in the present embodiment may further include the step of polishing a main surface of SiC substrate 20 corresponding to main surface 20A of SiC substrate 20 opposite to base substrate 10 in the stack substrate. Thus, silicon carbide substrate 1 in which main surface 20A of SiC layer 20 opposite to base substrate 10 is polished can be manufactured. Here, the polishing step may be performed before or after bonding between base substrate 10 and SiC substrate 20, so long as it is performed after the step (S10).

### (Second Embodiment)

A second embodiment representing another embodiment of the present invention will now be described. Referring to Fig. 3, basically, silicon carbide substrate 1 in the second embodiment has a construction similar to that of silicon carbide substrate 1 in the first embodiment, achieves a similar effect, and can be manufactured similarly. Silicon carbide substrate 1 in the second embodiment, however, is different from that in the first embodiment in that a plurality of SiC layers 20 are stacked.

Namely, referring to Fig. 3, silicon carbide substrate 1 in the second embodiment includes a plurality of (two in the present embodiment) SiC layers 20 on base substrate 10. Thus, silicon carbide substrate 1 in the present embodiment is a silicon carbide substrate including SiC layers 20 in accordance with an intended structure of a semiconductor device. More specifically, for example when silicon carbide substrate 1 is used for manufacturing a vertical power device (vertical MOSFET; Metal Oxide Semiconductor Field Effect Transistor and the like), impurity density in base substrate 10 is preferably increased in order to lower resistivity in a direction of stack (a direction of thickness) in silicon carbide substrate 1 as much as possible. On the other hand, as impurity density in base substrate 10 is higher, a lattice constant of SiC forming base substrate 10 varies. Therefore, when SiC substrate 20 significantly lower in impurity density than base substrate 10 high in impurity density is directly bonded onto base substrate 10, strain or warpage of obtained silicon carbide substrate 1 may be great due to difference in lattice constant between base substrate 10 and SiC substrate 20 and density of crystal defects may become high. In contrast, by sandwiching another SiC substrate 20 of which impurity density is intermediate between base substrate 10 high in impurity density and SiC substrate 20 low in impurity density to thereby gradually vary a lattice constant in a direction of thickness of silicon carbide substrate 1, occurrence of such a problem can be suppressed.

A method of manufacturing silicon carbide substrate 1 according to the second embodiment will now be described. Silicon carbide substrate 1 according to the second embodiment can be carried out as in the first embodiment, by stacking a plurality of (two) SiC substrates 20 on base substrate 10 in the step (S30) in the method of manufacturing silicon carbide substrate 1 in the first embodiment above. On the other hand, by adopting the following manufacturing process, silicon carbide substrate 1 including a plurality of SiC substrates 20 more securely bonded to one another can be manufactured.

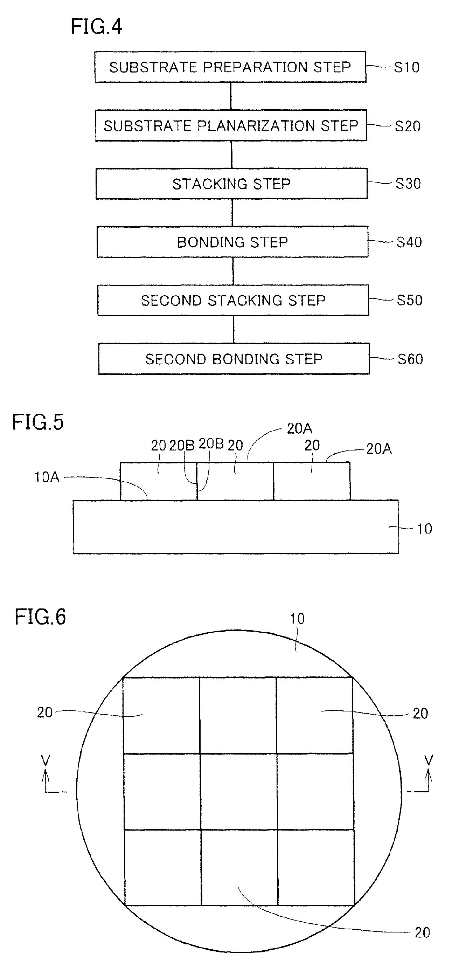

Namely, referring to Fig. 4, initially, the steps (S10) to (S40) are performed as in the first embodiment. Thereafter, in the step (S50), a second stacking step is performed. In this step (S50), a second stack substrate is fabricated by further stacking another SiC substrate 20 on SiC substrate 20 that was stacked on base substrate 10 in the step (S30) and bonded to base substrate 10 in the step (S40).

Then, a second bonding step is performed as the step (S60). In this step (S60), the stack substrate and another SiC substrate 20 are bonded to each other by heating the second stack substrate above as in the step (S40) above. By thus repeatedly performing the step of placing (stacking) SiC substrate 20 and bonding SiC substrate 20, silicon carbide substrate 1 in which a plurality of SiC layers 20 are stacked can readily be manufactured.

In the manufacturing method above, respective main surfaces (bonding surfaces) of SiC substrates 20 to be in contact with each other in the step (S50) may be planarized. Here, in order to more reliably bond SiC substrates 20 to each other, surface roughness Ra of the bonding surface above is preferably less than 100 nm and preferably less than 50 nm. Moreover, by setting surface roughness Ra of the bonding surface to less than 10 nm, further reliable bonding can be achieved. On the other hand, polishing for planarization above may be omitted and the step (S50) may be performed without polishing respective main surfaces of SiC substrates 20 to be in contact with each other. Cost for manufacturing silicon carbide substrate 1 can thus be reduced. Further, from a point of view of removal of a damaged layer around the surface caused by slicing or the like at the time of fabrication of SiC substrate 20, for example, the step of removing the damaged layer by etching may be performed instead of or after planarization above, and then the step (S50) may be performed.

### (Third Embodiment)

A third embodiment representing yet another embodiment of the present invention will now be described. Referring to Figs. 5 and 6, basically, silicon carbide substrate 1 in the third embodiment has a construction similar to that of silicon carbide substrate 1 in the first embodiment, achieves a similar effect, and can be manufactured similarly. Silicon carbide substrate 1 in the third embodiment, however, is different from that in the first embodiment in that a plurality of SiC layers 20 are two-dimensionally arranged in alignment.

Namely, referring to Figs. 5 and 6, in silicon carbide substrate 1 in the third embodiment, a plurality of (nine in the present embodiment) SiC layers 20 are two-dimensionally arranged in alignment. Namely, a plurality of SiC layers 20 are arranged in alignment along main surface 10A of base substrate 10. More specifically, nine SiC layers 20 are arranged in matrix such that SiC layers 20 adjacent on base substrate 10 are in contact with one another. Thus, silicon carbide substrate 1 in the present embodiment is silicon carbide substrate 1 that can be handled as a large-diameter substrate having high-quality SiC layers 20. Then, by employing this silicon carbide substrate 1, a process for manufacturing a semiconductor device can be more efficient. Referring again to Fig. 5, respective end surfaces 20B of adjacent SiC layers 20 are substantially perpendicular to main surface 20A of SiC layer 20. Thus, silicon carbide substrate 1 in the present embodiment can readily be manufactured. It is noted that silicon carbide substrate 1 in the third embodiment can be manufactured as in the first embodiment by two-dimensionally arranging in alignment a plurality of SiC substrates 20 of which end surfaces 20B are substantially perpendicular to main surface 20A in the step (S30).

The structures of the silicon carbide substrates in the second and third embodiments above may be combined with each other. Specifically, for example, SiC layer 20 may be arranged on base substrate 10 and a plurality of SiC layers 20 are two-dimensionally arranged in alignment on SiC layer 20. Such silicon carbide substrate 1 can be manufactured by two-dimensionally placing in alignment a plurality of SiC substrates 20 of which end surfaces 20B are substantially perpendicular to main surface 20A in the step (S50) in the manufacturing method described with reference to Fig. 4 in the second embodiment above.

In silicon carbide substrate 1 in the embodiment above, silicon carbide forming SiC layer 20 preferably has a hexagonal crystal structure and the crystal structure is more preferably 4H-SiC. In addition, base substrate 10 and SiC layer 20 (in a case where a plurality of SiC layers 20 are included, adjacent SiC layers 20 as well) are preferably composed of silicon carbide single crystal identical in crystal structure. By thus adopting silicon carbide single crystal identical in crystal structure for base substrate 10 and SiC layer 20, physical properties such as a coefficient of thermal expansion are matched up, and warpage of silicon carbide substrate 1, separation between base substrate 10 and SiC layer 20, or occurrence of separation between SiC layers 20 during the process for manufacturing a silicon carbide substrate and a semiconductor device including the silicon carbide substrate can be suppressed.

Further, in SiC layer 20 and base substrate 10 (in a case where a plurality of SiC layers 20 are included, adjacent SiC layers 20 as well), an angle between c axes of silicon carbide single crystals forming them is preferably smaller than 1° and more preferably smaller than 0.1°. Furthermore, preferably, a c plane of silicon carbide single crystal does not rotate in the plane.

Base substrate 10 has a diameter preferably not smaller than 2 inches and more preferably not smaller than 6 inches. In addition, silicon carbide substrate 1 has a thickness preferably not smaller than 200 µm and not greater than 1000 µm, and more preferably not smaller than 300 µm and not greater than 700 µm. Further, SiC layer 20 has resistivity preferably not higher than 50 mΩcm and more preferably not higher than 20 mΩcm.

### (Fourth Embodiment)

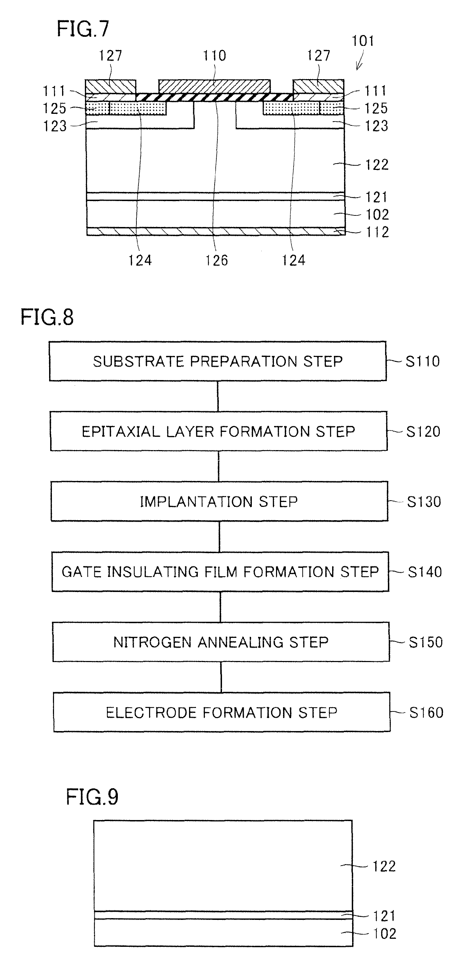

One example of a semiconductor device fabricated with the silicon carbide substrate according to the present invention above will now be described as a fourth embodiment. Referring to Fig. 7, a semiconductor device 101 according to the present invention is a vertical DiMOSFET (Double Implanted MOSFET), and includes a substrate 102, a buffer layer 121, a breakdown voltage holding layer 122, a p region 123, an n⁺ region 124, a p⁺ region 125, an oxide film 126, a source electrode 111 and an upper source electrode 127, a gate electrode 110, and a drain electrode 112 formed on a back surface side of substrate 102. Specifically, buffer layer 121 composed of silicon carbide is formed on a surface of substrate 102 composed of silicon carbide having an n conductivity type. A silicon carbide substrate according to the present invention including silicon carbide substrate 1 described in the first to third embodiments above is adopted as substrate 102. Then, in a case where silicon carbide substrate I in the first to third embodiments above is adopted, buffer layer 121 is formed on SiC layer 20 of silicon carbide substrate 1. Buffer layer 121 has an n conductivity type and a thickness, for example, of 0.5 µm. In addition, density of an n-type conductive impurity in buffer layer 121 can be, for example, 5×10¹⁷ cm⁻³. Breakdown voltage holding layer 122 is formed on this buffer layer 121. This breakdown voltage holding layer 122 is composed of silicon carbide having an n conductivity type and it has a thickness, for example, of 10 µm. In addition, such a value as 5×10¹⁵ cm⁻³ can be adopted as density of an n-type conductive impurity in breakdown voltage holding layer 122.

In a surface of this breakdown voltage holding layer 122, p regions 123 having a p conductivity type are formed at a distance from one another. In the inside of p region 123, n⁺ region 124 is formed in a surface layer of p region 123. In addition, p⁺ region 125 is formed at a position adjacent to this n⁺ region 124. Oxide film 126 is formed to extend from n⁺ region 124 in one p region 123 to p region 123, breakdown voltage holding layer 122 exposed between two p regions 123, the other p region 123, and n⁺ region 124 in the other p region 123. Gate electrode 110 is formed on oxide film 126. Further, source electrode 111 is formed on n⁺ region 124 and p⁺ region 125. Upper source electrode 127 is formed on this source electrode 111. Moreover, in substrate 102, drain electrode 112 is formed on the back surface which is a surface opposite to a front surface where buffer layer 121 is formed.

In semiconductor device 101 in the present embodiment, a silicon carbide substrate according to the present invention such as silicon carbide substrate 1 described in the first to third embodiments above is adopted as substrate 102. Namely, semiconductor device 101 includes substrate 102 which is a silicon carbide substrate, buffer layer 121 and breakdown voltage holding layer 122 as epitaxially grown and formed on substrate 102, and source electrode 111 formed on breakdown voltage holding layer 122. This substrate 102 is a silicon carbide substrate according to the present invention such as silicon carbide substrate 1. Here, as described above, the silicon carbide substrate according to the present invention is a silicon carbide substrate allowing reduction in cost for manufacturing a semiconductor device. Therefore, semiconductor device 101 is a semiconductor device of which manufacturing cost has been reduced.

A method of manufacturing semiconductor device 101 shown in Fig. 7 will now be described with reference to Figs. 8 to 12. Referring to Fig. 8, initially, a substrate preparation step (S 110) is performed. Here, substrate 102 (see Fig. 9) composed of silicon carbide having, for example, a (03-313) plane as the main surface is prepared. The silicon carbide substrate according to the present invention above, including silicon carbide substrate 1 manufactured with the manufacturing method described in the first to third embodiments above, is prepared as this substrate 102.

Alternatively, a substrate, for example, having an n conductivity type and a substrate resistance of 0.02 Ωcm may be employed as this substrate 102 (see Fig. 9).

Then, as shown in Fig. 8, an epitaxial layer formation step (S120) is performed. Specifically, buffer layer 121 is formed on the surface of substrate 102. This buffer layer 121 is formed on SiC layer 20 (see Figs. 1, 3, and 5) of silicon carbide substrate 1 adopted as substrate 102. An epitaxial layer composed of silicon carbide having an n conductivity type and having a thickness, for example, of 0.5 µm is formed as buffer layer 121. For example, such a value as 5×10¹⁷ cm⁻³ can be adopted as density of a conductive impurity in buffer layer 121. Then, as shown in Fig. 9, breakdown voltage holding layer 122 is formed on this buffer layer 121. A layer composed of silicon carbide having an n conductivity type is formed as this breakdown voltage holding layer 122 with an epitaxial growth method. For example, such a value as 10 µm can be adopted as a thickness of this breakdown voltage holding layer 122. Further, such a value as 5×10¹⁵ cm⁻³ can be adopted as density of an n-type conductive impurity in this breakdown voltage holding layer 122.

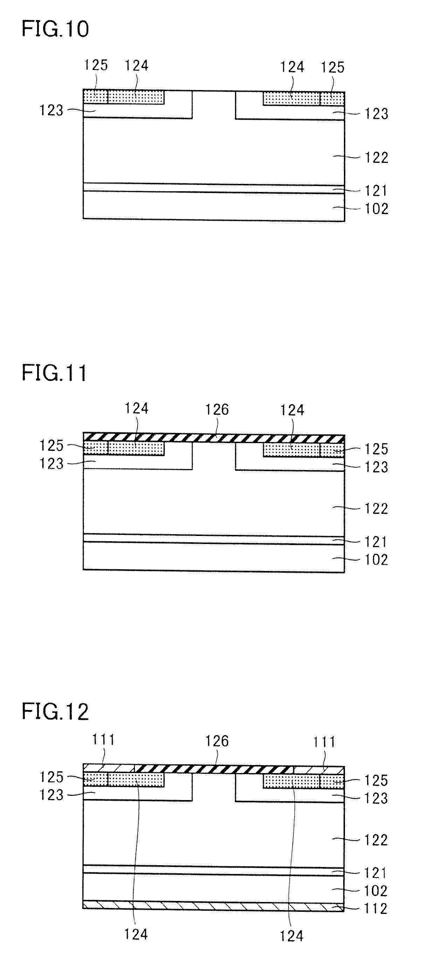

Then, as shown in Fig. 8, an implantation step (S 130) is performed. Specifically, using an oxide film formed with photolithography and etching as a mask, an impurity having a p conductivity type is implanted into breakdown voltage holding layer 122, to thereby form p region 123 as shown in Fig. 10. After the used oxide film is removed, an oxide film having a new pattern is again formed with photolithography and etching. Then, using this oxide film as a mask, an n-type conductive impurity is implanted into a prescribed region to thereby form n⁺ region 124. By implanting a conductive impurity having a p conductivity type with the similar technique, p⁺ region 125 is formed. Consequently, a structure as shown in Fig. 10 is obtained.

After such an implantation step, activation annealing treatment is performed. For example, for this activation annealing treatment, an argon gas is used as an atmospheric gas and such conditions as a heating temperature of 1700°C and a heating time period of 30 minutes can be employed.

Then, as shown in Fig. 8, a gate insulating film formation step (S140) is performed. Specifically, as shown in Fig. 11, oxide film 126 is formed to cover breakdown voltage holding layer 122, p region 123, n⁺ region 124, and p⁺ region 125. For example, dry oxidation (thermal oxidation) may be carried out as a condition for forming this oxide film 126. Such conditions as a heating temperature of 1200°C and a heating time period of 30 minutes can be employed as conditions in this dry oxidation.

Thereafter, as shown in Fig. 8, a nitrogen annealing step (S 150) is performed. Specifically, annealing treatment is performed with nitrogen monoxide (NO) being employed as an atmospheric gas. As a temperature condition for annealing treatment, for example, a heating temperature of 1100°C and a heating time period of 120 minutes are set. Consequently, nitrogen atoms are introduced in the vicinity of an interface between oxide film 126 and each of breakdown voltage holding layer 122, p region 123, n⁺ region 124, and p⁺ region 125 located below. After this annealing step using nitrogen monoxide as the atmospheric gas, annealing using an argon (Ar) gas which is an inert gas may further be performed. Specifically, an argon gas is used as an atmospheric gas and such conditions as a heating temperature of 1100°C and a heating time period of 60 minutes may be adopted.

Then, as shown in Fig. 8, an electrode formation step (S 160) is performed. Specifically, a resist film having a pattern is formed on oxide film 126 with photolithography. Using this resist film as a mask, a portion of the oxide film located on n⁺ region 124 and p⁺ region 125 is etched away. Thereafter, a conductor film made of a metal or the like is formed on the resist film and in an opening formed in oxide film 126, to be in contact with n⁺ region 124 and p⁺ region 125. Thereafter, by removing the resist film, the conductor film that has been located on the resist film is removed (lift-off). Here, for example, nickel (Ni) can be used as the conductor. Consequently, as shown in Fig. 12, source electrode 111 and drain electrode 112 can be obtained. It is noted that heat treatment for alloying is preferably performed here. Specifically, heat treatment (alloying treatment) using, for example, an argon (Ar) gas representing an inert gas as an atmospheric gas, with a heating temperature being set to 950°C and a heating time period being set to 2 minutes, is performed.

Thereafter, upper source electrode 127 (see Fig. 7) is formed on source electrode 111. In addition, gate electrode 110 (see Fig. 7) is formed on oxide film 126. Semiconductor device 101 shown in Fig. 7 can thus be obtained.

Though a vertical MOSFET has been described in the fourth embodiment above by way of example of a semiconductor device that can be fabricated with a silicon carbide substrate according to the present invention, a semiconductor device that can be fabricated is not limited thereto. For example, various semiconductor devices such as a JFET (Junction Field Effect Transistor), an IGBT (Insulated Gate Bipolar Transistor), and a Schottky barrier diode can be fabricated with the silicon carbide substrate according to the present invention. In addition, though a case of fabricating a semiconductor device by forming an epitaxial layer functioning as an operating layer on the silicon carbide substrate having a (03-38) plane as the main surface has been described in the fourth embodiment above, a crystal plane that can be adopted as the main surface above is not limited thereto and any crystal plane in accordance with applications including the (0001) plane can be adopted as the main surface above.

### Examples

### (Example 1)

Example 1 according to the present invention will be described below. Various substrates composed of silicon carbide single crystal were prepared and experiments for examining whether substrates could be bonded to each other or not with a heating temperature being varied were conducted. An experiment procedure is as follows.

Initially, an experiment method will be described. Substrates having such characteristics as shown in Table 1 below were prepared and the substrates were held for 3 hours in an inert gas atmosphere at a temperature of 1950°C and at a pressure of 1 Pa in a heating furnace while polished surfaces were in contact with each other. Thereafter, a sample was taken out of the heating furnace, whether bonding was achieved or not was checked, and an angle between c axes of silicon carbide single crystals forming adjacent substrates was measured. In a sample A, bonding between conductive substrates (substrates 1 and 2) different from each other in micropipe density, threading screw dislocation density, threading edge dislocation density, basal plane dislocation density, composite dislocation density, and stacking fault density was attempted. In addition, in a sample B, bonding between a conductive substrate (substrate 1) and a semi-insulating substrate (substrate 2) different from each other in poly type was attempted. Moreover, in a sample C, bonding among three substrates (substrates 1 to 3) was attempted. It is noted that surface roughness Ra in Table 1 represents roughness at a bonding surface where contact with each other is made. Here, surface roughness in a square region having one side of 10 µm was measured as surface roughness Ra. Further, an off angle represents an off angle of a main surface with respect to plane orientation (0001) in the <11-20> direction. Furthermore. "-" indicates that measurement was not conducted.

In addition, for comparison, an experiment for checking whether bonding could be achieved or not in samples A to C above by holding them for 3 hours in an inert gas atmosphere at a temperature of 1800°C and at a pressure of 133 Pa in a heating furnace was also conducted.

**Table 1**

| | | Size; Diameter φ (inches) | Thickness (µm) | Surface Roughness Ra (nm) | Poly Type | Off Angle (°) | Micropipe Density (cm⁻²) | Threading Screw Dislocation Density | Threading Edge Dislocation Density (cm⁻²) | Basal Plane Dislocation Density (cm⁻²) | Composite Dislocation Density (cm⁻²) | Stacking Fault Density (cm⁻¹) | n-type Impurity Density (cm⁻³) | Resistivity (Ω·cm) |
|---|---|---|---|---|---|---|---|---|---|---|---|---|---|---|
| Sample A | Substrate 1 | 4 | 400 | 50 | 4H | 8 | 1×10³ | 2×10³ | 1×10⁴ | 3×10⁴ | 6×10³ | 1×10⁵ | 1×10²⁰ | - |
| | Substrate 2 | 2 | 400 | 50 | 4H | 8 | 1×10¹ | 1×10² | 5×10³ | 1×10⁴ | 2×10³ | 1×10⁰ | 1×10¹⁹ | - |
| Sample B | Substrate 1 | 2 | 400 | 50 0 | 4H | 8 | - | - | - | - | - | - | - | 0.020 |
| | Substrate 2 | 2 | 300 | 40 | 6H | 0 | - | - | - | - | - | - | - | >10⁶ |
| Sample C | Substrate 1 | 2 | 400 | 50 | 4H | 8 | - | - | - | - | - | - | 9×10¹⁸ | - |
| | Substrate 2 | 2 | 400 | 50 | 4H | 8 | - | - | - | - | - | - | 3×10¹⁹ | - |
| | Substrate 3 | 2 | 400 | 50 | 4H | 8 | - | - | - | - | - | - | 1×10²⁰ | ₋ |

Results of the experiment will now be described. In each of samples A to C for which bonding was carried out under such a condition as holding for 3 hours in an inert gas atmosphere at a temperature of 1950°C and at a pressure of 1 Pa, secure bonding was achieved. An angle between the c axes of silicon carbide single crystals forming the substrates in sample A was 0.1°, and an angle between the c axes in sample B was 8°. In addition, an angle between the c axes of respective substrates 1 and 2 in sample C was 0.3°, and an angle between the c axes of respective substrates 2 and 3 was 0.1°. Based on this fact, it was confirmed that a silicon carbide substrate can be manufactured by bonding substrates different in fault density, conductivity (impurity density) and poly type to each other and a silicon carbide substrate can be manufactured by bonding three substrates as they are stacked.

On the other hand, bonding could be achieved in none of samples A to C for which bonding was carried out under such a condition as holding for 3 hours in an inert gas atmosphere at a temperature of 1800°C and at a pressure of 133 Pa. Based on this fact, it was confirmed that a heating temperature was important in bonding between substrates composed of silicon carbide single crystal, and, in order to efficiently achieve bonding, a heating temperature was desirably 1950°C or higher, which was equal to or higher than a temperature at which SiC sublimated.

Warpage in sample C in which substrates 1,2 and 3 having n-type impurity densities of 9×10¹⁸ cm⁻³, 3×10¹⁹ cm⁻³ and 1×10²⁰ cm⁻³ respectively were bonded in this order was 10 µm. In contrast, a sample in which substrate 1 and substrate 3 were directly bonded to each other was also fabricated, and its warpage was 50 µm. Based on this fact, it was confirmed that warpage of the bonded substrate could be lessened by bonding a substrate high in impurity density and a substrate low in impurity density with another substrate having impurity density intermediate therebetween being interposed so that a lattice constant gradually varied in a direction of thickness of the obtained bonded substrate.

### (Example 2)

Example 2 according to the present invention will be described below. An experiment for studying whether substrates of which respective main surfaces were greatly inclined with respect to the (0001) plane (substrates each having a main surface of which off angle with respect to plane orientation {0001} was not smaller than 50° and not greater than 65°) could be bonded to each other or not and whether a substrate of which main surface was greatly inclined with respect to the (0001) plane and a substrate having the (0001) plane as the main surface could be bonded to each other or not was conducted. An experiment procedure is as follows.

Initially, an experiment method will be described. Substrates having such characteristics as shown in Table 2 below were prepared and the substrates were held for 3 hours in an inert gas atmosphere at a temperature of 1950°C and at a pressure of 1 Pa in a heating furnace while main surfaces were brought in contact with each other. Thereafter, the sample was taken out of the heating furnace and whether bonding was achieved or not was checked.

**Table 2**

| | | Size | Thickness (µm) | Surface Roughness Ra (µm) | Poly Type | Orientation | Micropipe Plane Density (cm⁻²) | Stacking Fault Density (cm⁻¹) | n-type Impurity Density (cm⁻³) |
|---|---|---|---|---|---|---|---|---|---|
| Sample D | Substrate 1 | φ 4 inches | 300 | 3 | 4H | (03-38) | 1 | 1×10⁵ | 1×10²⁰ |
| | Substrate 2 | 30 mm long and 62 mm wide | 150 | 3 | 4H | (03-38) | 0 | <1 | 1×10¹⁹ |
| Sample E | Substrate 1 | φ 4 inches | 400 | 8 | 4H | (0001) | 1×10³ | 1×10⁵ | 1×10²⁰ |
| | Substrate 2 | 30 mm long and 62 mm wide | 200 | 3 | 4H | (03-38) | 0 | <1 | 1×10¹⁹ |

Results of the experiment will now be described. In each of samples D and E for which bonding was carried out under such a condition as holding for 3 hours in an inert gas atmosphere at a temperature of 1950°C and at a pressure of 1 Pa, secure bonding was achieved. Based on this fact, it was confirmed that the substrate of which main surface was greatly inclined with respect to the (0001) plane could readily be bonded to both of the substrate of which main surface was similarly greatly inclined with respect to the (0001) plane and the substrate having the (0001) plane as the main surface.

### (Example 3)

An experiment for checking relation of crystal orientation between the base substrate and the SiC layer in a silicon carbide substrate obtained with the method of manufacturing a silicon carbide substrate according to the present invention was conducted. An experiment procedure is as follows.

Initially, two substrates (base substrate 10 and SiC substrate 20) each composed of SiC and having the (03-38) plane as the main surface were prepared. Then, the two substrates were layered such that the main surfaces were in contact with each other to fabricate the stack substrate. The stack substrate was heated to 2100°C which was equal to or higher than a sublimation temperature of SiC so that the two substrates were bonded to each other under such a condition as holding for 30 hours in a nitrogen gas atmosphere at a pressure of 1 Pa. A silicon carbide substrate was thus fabricated. Here, a temperature of base substrate 10 was maintained at a temperature slightly higher than that of SiC substrate 20. Then, crystal orientation in a cross-section perpendicular to the bonding surface of the obtained silicon carbide substrate was examined with an electron back scatter diffraction (EBSD) method.

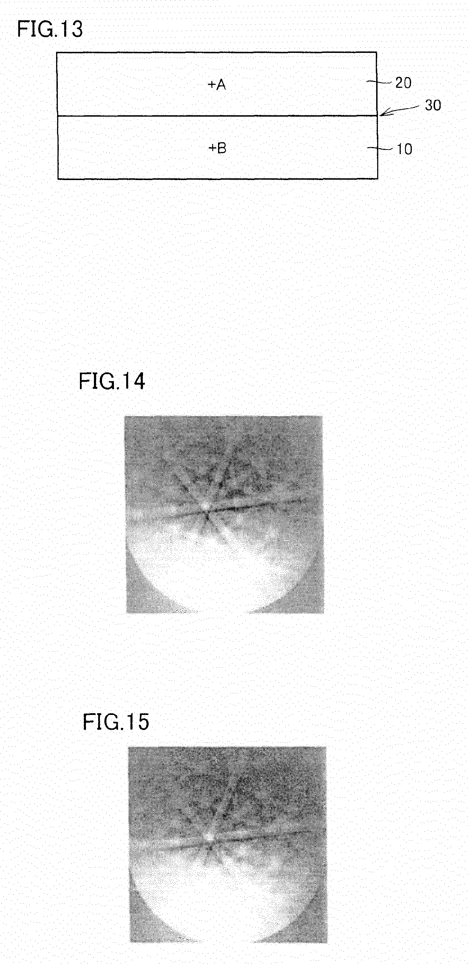

Results of the experiment will now be described. Referring to Fig. 13, it can be seen by comparing an EBSD pattern (Fig. 14) at a position A in SiC layer 20 and an EBSD pattern (Fig. 15) at a position B in base substrate 10, that are arranged across a boundary 30, with each other, that these positions match with each other. Therefore, it can be seen that SiC crystal forming base substrate 10 and SiC crystal forming SiC layer 20 are identical in a direction of the c axis and there is no rotation in the c plane. This may be because SiC crystal forming base substrate 10 and SiC crystal forming SiC layer 20 were identical in crystal orientation as a result of the fact that bonding between base substrate 10 and SiC substrate 20 was achieved by sublimation of base substrate 10 held at a temperature slightly higher than SiC substrate 20.

### (Example 4)

An experiment for examining relation between a size of a gap formed between the base substrate and the SiC substrate during bonding of the stack substrate and a state of bonding of the stack substrate was conducted. Initially, as in the case of Example 3 above, the two substrates (base substrate 10 and SiC substrate 20) were prepared and two substrates were layered such that main surfaces thereof were brought in contact with each other. The stack substrate was thus fabricated. Here, adjustment was made such that a gap formed between the two substrates was from 0.5 to 1000 µm wide. Then, as in Example 3 above, the stack substrate above was heated to 2100°C and held for 30 hours in a nitrogen gas atmosphere at a pressure of 1 Pa. Then, a state of bonding of the stack substrate after the treatment was checked. Table 3 shows results of the experiment.

**Table 3**

| Gap (µm) | 0.5 | 1 | 10 | 50 | 100 | 200 | 1000 |
|---|---|---|---|---|---|---|---|
| State of Bonding | A | A | A | A | A | B | C |

| | | | | | | | |
|---|---|---|---|---|---|---|---|
| A: uniform bonding B: partial bonding C: bonding unsuccessful | | | | | | | |

In Table 3, a sample in which two substrates were uniformly bonded to each other over the entire region was denoted as A, a sample in which only partial bonding was achieved was denoted as B, and a sample in which bonding between the two substrates was unsuccessful was denoted as C. As shown in Table 3, it was confirmed that, in order to achieve uniform bonding, a gap formed between the base substrate and the SiC substrate was preferably not greater than 100 µm.

As described in the fourth embodiment above, a semiconductor device can be fabricated with the silicon carbide substrate according to the present invention. Namely, in the semiconductor device according to the present invention, an epitaxially grown layer serving as an operating layer is formed on the silicon carbide substrate manufactured with the method of manufacturing a silicon carbide substrate according to the present invention above. Giving the description from a different point of view, in the semiconductor device according to the present invention, an epitaxially grown layer serving as an operating layer is formed on the silicon carbide substrate according to the present invention above. More specifically, the semiconductor device according to the present invention includes the silicon carbide substrate according to the present invention above, an epitaxially grown layer formed on the silicon carbide substrate, and an electrode formed on the epitaxially grown layer. Namely, the semiconductor device according to the present invention includes a base substrate composed of silicon carbide, an SiC layer composed of single crystal silicon carbide and arranged on the base substrate in contact therewith, an epitaxially grown layer formed on the SiC layer, and an electrode formed on the epitaxially grown layer.

It should be understood that the embodiments and the examples disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

A silicon carbide substrate and a method of manufacturing the same according to the present invention are particularly advantageously applicable to a silicon carbide substrate used for manufacturing a semiconductor device required to be low in manufacturing cost and a method of manufacturing the same. In addition, a semiconductor device according to the present invention is particularly advantageously applicable to a semiconductor device required to be low in manufacturing cost.

### REFERENCE SIGNS LIST

1 silicon carbide substrate; 10 base substrate; 10A main surface; 20 SiC layer (SiC substrate); 20A main surface; 20B end surface; 30 boundary; 101 semiconductor device; 102 substrate; 110 gate electrode; 111 source electrode; 112 drain electrode; 121 buffer layer; 122 breakdown voltage holding layer; 123 p region; 124 n⁺ region; 125 p⁺ region; 126 oxide film; and 127 upper source electrode.

## Claims

1. A silicon carbide substrate (1), comprising:
a base substrate (10) composed of silicon carbide; and
an SiC layer (20) composed of single crystal silicon carbide different from said base substrate (10) and arranged on said base substrate (10) in contact therewith.

2. The silicon carbide substrate (1) according to claim 1, wherein
said base substrate (10) is composed of single crystal silicon carbide, and
said SiC layer (20) is lower in micropipe density than said base substrate (10).

3. The silicon carbide substrate (1) according to claim 1. wherein
said base substrate (10) is composed of single crystal silicon carbide, and
said SiC layer (20) is lower in dislocation density than said base substrate (10).

4. The silicon carbide substrate (1) according to claim 1, wherein
said base substrate (10) is composed of single crystal silicon carbide, and
said SiC layer (20) is smaller in a full width at half maximum of X-ray rocking curve than said base substrate (10).

5. The silicon carbide substrate (1) according to claim 1, wherein
said base substrate (10) includes a single crystal layer (10B) composed of single crystal silicon carbide so as to include a main surface (10A) on a side facing said SiC layer (20).

6. The silicon carbide substrate (1) according to claim 5, wherein
said SiC layer (20) is lower in micropipe density than said single crystal layer (10B).

7. The silicon carbide substrate (1) according to claim 5, wherein
said SiC layer (20) is lower in dislocation density than said single crystal layer (10B).

8. The silicon carbide substrate (1) according to claim 5, wherein
said SiC layer (20) is smaller in a full width at half maximum of X-ray rocking curve than said single crystal layer (10B).

9. The silicon carbide substrate (1) according to claim 1, wherein
a plurality of said SiC layers (20) are two-dimensionally arranged in alignment.

10. The silicon carbide substrate (1) according to claim 5, wherein
a plurality of said SiC layers (20) are two-dimensionally arranged in alignment.

11. The silicon carbide substrate (1) according to claim 1, wherein
a main surface (20A) of said SiC layer (20) opposite to said base substrate (10) has an off angle with respect to a plane orientation {0001} not smaller than 50° and not greater than 65°.

12. The silicon carbide substrate (1) according to claim 11. wherein
an angle between an off orientation of said main surface (20A) and a <1-100> direction is not greater than 5°.

13. The silicon carbide substrate (1) according to claim 12, wherein
an off angle of said main surface (20A) with respect to a {03-38} plane in the <1-100> direction is not smaller than -3° and not greater than 5°.

14. The silicon carbide substrate (1) according to claim 11, wherein an angle between an off orientation of said main surface (20A) and a <11-20> direction is not greater than 5°.

15. The silicon carbide substrate (1) according to claim 1, wherein
a main surface (20A) of said SiC layer (20) opposite to said base substrate (10) is polished.

16. A semiconductor device (101), comprising:
a silicon carbide substrate (102);
an epitaxially grown layer (122) formed on said silicon carbide substrate (102); and
an electrode (111) formed on said epitaxially grown layer (122),
said silicon carbide substrate (102) being the silicon carbide substrate (1) according to claim 1.

17. A method of manufacturing a silicon carbide substrate (1), comprising the steps of:
preparing a base substrate (10) composed of silicon carbide and an SiC substrate (20) composed of single crystal silicon carbide;
fabricating a stack substrate by placing said SiC substrate (20) on a main surface (10A) of said base substrate (10) in contact therewith; and
bonding said base substrate (10) and said SiC substrate (20) to each other by heating said stack substrate.

18. The method of manufacturing a silicon carbide substrate (1) according to claim 17, wherein
in said stack substrate, a gap formed between said base substrate (10) and said SiC substrate (20) is not greater than 100 µm.

19. The method of manufacturing a silicon carbide substrate (1) according to claim 17, wherein
in said step of bonding said base substrate (10) and said SiC substrate (20) to each other, said stack substrate is heated to a temperature range not lower than a sublimation temperature of silicon carbide.

20. The method of manufacturing a silicon carbide substrate (1) according to claim 17, further comprising the step of planarizing respective main surfaces of said base substrate (10) and said SiC substrate (20) to be in contact with each other in said step of fabricating a stack substrate, prior to said step of fabricating a stack substrate.

21. The method of manufacturing a silicon carbide substrate (1) according to claim 17, wherein
said step of fabricating a stack substrate is performed without polishing respective main surfaces of said base substrate (10) and said SiC substrate (20) to be in contact with each other in said step of fabricating a stack substrate, prior to said step of fabricating a stack substrate.

22. The method of manufacturing a silicon carbide substrate (1) according to claim 17, wherein
in said step of fabricating a stack substrate, a plurality of said SiC substrates (20) are two-dimensionally placed in alignment.

23. The method of manufacturing a silicon carbide substrate (1) according to claim 17, wherein
in said step of fabricating a stack substrate, a main surface (20A) of said SiC substrate (20) opposite to said base substrate (10) has an off angle with respect to a {0001} plane not smaller than 50° and not greater than 65°.

24. The method of manufacturing a silicon carbide substrate (1) according to claim 23, wherein
in said step of fabricating a stack substrate, an angle between an off orientation of the main surface (20A) of said SiC substrate (20) opposite to said base substrate (10) and a <1-100> direction is not greater than 5°.

25. The method of manufacturing a silicon carbide substrate (1) according to claim 24, wherein
in said step of fabricating a stack substrate, an off angle of the main surface (20A) of said SiC substrate (20) opposite to said base substrate (10) with respect to a {03-38} plane in the <1-100> direction is not smaller than -3° and not greater than 5°.

26. The method of manufacturing a silicon carbide substrate (1) according to claim 23, wherein
in said step of fabricating a stack substrate, an angle between an off orientation of the main surface (20A) of said SiC substrate (20) opposite to said base substrate (10) and a <11-20> direction is not greater than 5°.

27. The method of manufacturing a silicon carbide substrate (1) according to claim 17, wherein
in said step of bonding said base substrate (10) and said SiC substrate (20) to each other, said stack substrate is heated in an atmosphere obtained by reducing a pressure of an ambient air atmosphere.

28. The method of manufacturing a silicon carbide substrate (1) according to claim 17, wherein
in said step of bonding said base substrate (10) and said SiC substrate (20) to each other, said stack substrate is heated at a pressure higher than 10⁻¹ Pa and lower than 10⁴ Pa.

29. The method of manufacturing a silicon carbide substrate (1) according to claim 17, further comprising the step of polishing a main surface of said SiC substrate (20) corresponding to a main surface (20A) of said SiC substrate (20) opposite to said base substrate (10) in said stack substrate.
